# EUROPÄISCHE PATENTSCHRIFT

(11) **EP 4 327 568 B1**
(45) Veröffentlichungstag und Bekanntmachung des Hinweises auf die Patenterteilung: **03.06.2026**
(21) Anmeldenummer: 22721051.5
(22) Anmeldetag: 06.04.2022
(51) Int. Cl.: H04R 31/00, H04R 17/00, H04R 7/10, G01B 17/02

(54) **VERFAHREN UND ANORDNUNG ZUR FÜGUNG EINES PIEZOELEKTRISCHEN MATERIALS FÜR EINEN WEITEN TEMPERATURBEREICH**
METHOD AND ARRANGEMENT FOR JOINING A PIEZOELECTRIC MATERIAL FOR A WIDE TEMPERATURE RANGE
PROCÉDÉ ET AGENCEMENT D'ASSEMBLAGE D'UN MATÉRIAU PIÉZOÉLECTRIQUE POUR UNE LARGE PLAGE DE TEMPÉRATURES

(30) Priorität: 20.04.2021 DE 102021109992
(43) Veröffentlichungstag der Anmeldung: 28.02.2024
(73) Patentinhaber: FLEXIM Flexible Industriemesstechnik GmbH, 12681 Berlin (DE)
(72) Erfinder: SHAPOVALOV, Oleg, 03044 Cottbus (DE); HECKEL, Thomas, 14532 Kleinmachnow (DE); BOEHM, Rainer, 15848 Rietz-Neuendorf (DE); GÖBBELS, Stefan, 13256 Berlin (DE); FUNCK, Bernhard, 18059 Rostock (DE)
(74) Vertreter: Ellis, Christopher Paul
(86) Internationale Anmeldenummer: PCT/EP2022/059132
(87) Internationale Veröffentlichungsnummer: WO 2022/223299

(56) Entgegenhaltungen:
- DE-A1- 102012 202 074
- DE-A1- 102015 101 878
- DE-T5- 112015 006 135

## Beschreibung

### FACHGEBIET

Die Erfindung liegt auf dem Gebiet der Entwicklung und Herstellung von Schallwandlersystemen, insbesondere eines Ultraschallwandlersystems, für einen dauerhaften Hochtemperatureinsatz, betrifft aber ebenso allgemein das Fügen eines Metalls und eines piezoelektrischen Materials.

### HINTERGRUND

Bei der Ultraschalldurchflussmessung oder der Strukturzustandsüberwachung werden für die Wandlung der elektrischen Signale in Ultraschallsignale und umgekehrt Schallwandlersysteme verwendet. Solche Schallwandlersysteme bestehen aus einem piezoelektrischen Material zur Umwandlung zwischen elektrischen und akustischen Signalen und dem Vorlaufkörper für die Schallübertragung zwischen dem piezoelektrischen Material und dem Messobjekt bzw. dem Prüfling. Als piezoelektrische Materialien werden Piezokeramiken oder Piezokristalle verwendet. Vorbekannte Schallwandlersysteme eignen sich dauerhaft nur für den Einsatz im vergleichsweise engen Temperaturbereich von -40° bis 200°C. Vorliegend soll ein Temperaturbereich von -200 °C bis 600 °C abgedeckt werden. Ein derartiger Temperaturbereich ist beispielsweise für Anwendungen in der chemischen Industrie, beispielsweise für die Ultraschalldurchflussmessung, oder zur Strukturzustandsüberwachung charakteristisch. In der chemischen Industrie wird der Temperaturbereich von -200°C bis 600°C, insbesondere der Temperaturbereich von -20°C bis 500°C und der Temperaturbereich von -200°C bis 80°C verwendet und in der Strukturzustandsüberwachung wird der Temperaturbereich von -80°C bis 400°C verwendet.

Typischerweise müssen bisher für den Einsatz in einem so breiten Temperaturintervall mehrere Schallwandlersysteme parallel betrieben werden, wobei die Wandlersysteme unterschiedliche Sensorkonzepte nutzen. Daraus ergeben sich Nachteile, insbesondere durch unterschiedliche Signal/Rauschverhältnisse der einzelnen Wandler und die daraus resultierend unzureichende Messgenauigkeit. Eine Kombination verschiedener Schallwandlersysteme mit überlappenden Temperaturbereichen ist mit erheblichem Aufwand verbunden. Bekannte Schallwandlersysteme, die ein breiteres Temperaturintervall abdecken können, sind zudem ausschließlich für den Kurzzeitbetrieb geeignet. Systeme, die nur einen Kurzzeitbetrieb zulassen, sind jedoch für viele Anwendungen, beispielsweise für eine Ultraschalldurchflussmessung oder zur Strukturzustandsüberwachung ungeeignet, da beide Anwendungen kontinuierliche Messungen erfordern.

An ein Schallwandlersystem, das über einen weiten Temperaturbereich, insbesondere auch unter Hochtemperaturbedingungen bis 600 °C, einsetzbar ist, werden zudem besondere Anforderungen hinsichtlich einer dauerhaft zuverlässigen akustischen Ankoppelung des piezoelektrischen Materials gestellt. Hieraus ergibt sich das Erfordernis einer kraftschlüssigen, d.h. akustischen und/oder elektrischen Verbindung des piezoelektrischen Materials mit den beiden zur Ansteuerung des piezoelektrischen Materials verwendeten Elektroden und des piezoelektischen Materials mit dem Vorlaufkörper. Wie bekannt (s.u.), wird das im Stand der Technik beispielsweise durch eine flüssige Koppelschicht erreicht.

Eine der größten Herausforderungen bei der Entwicklung eines Ultraschallprüfkopfes für einen dauerhaften Extremtemperatureinsatz ist die Herstellung der temperaturbeständigen Ankopplung zwischen dem piezoelektrischen Material und dem Vorlaufkörper, der auch als Elektrode dient. Da die meisten konventionellen Klebematerialien in der Regel nur von ca. -40°C bis ca. 150 °C einsetzbar sind, kann eine feste stoffschlüssige Verbindung zwischen den einzelnen Komponenten nur durch hochtemperaturtaugliche Fügetechniken erzielt werden.

Ebenso kann die zuverlässige Verbindung von Metallelektroden mit einem piezoelektrischen Material, beispielsweise in einem Keramikfilter oder einem Zwischenfrequenzfilter, einem Keramikresonator, einem Piezoaktuator, oder für eine Keramikdurchführung eines Hochtemperatursensors extremen Betriebstemperaturen ausgesetzt sein.

Für die bezeichneten Belange kommen Lötverfahren, insbesondere das Metalllöten und das Glaslöten, in Betracht. Allerdings haben beide genannten Techniken jeweils eigene Nachteile. Da das zu verbindende hochtemperaturbeständige piezoelektrische Material zumeist ein oxidbasierter Werkstoff ist, wird der Einsatz konventioneller Metalllöttechnik durch die typischerweise sehr schlechte Benetzung des nichtmetallischem Materials durch die metallische Lotschmelze wesentlich erschwert.

Glaslötwerkstoffe weisen dagegen eine gute Benetzung gegenüber nichtmetallischen Materialien auf, haben allerdings mehrere andere Nachteile wie etwa:
- eine schlechte elektrische Leitfähigkeit, die zu einer Verringerung der wirksamen Feldstärke am piezoelektrischen Material führt;
- einen in der Regel relativ niedrigen (und in meisten Fällen unpassenden) Koeffizienten der Wärmeausdehnung, die zur Rissbildung in der Lotschicht und im piezoelektrischen Material führen kann;
- Sprödigkeit, die bei einer Temperaturänderung zur Rissbildung in der Koppelschicht und somit zur Verschlechterung der Koppeleigenschaften führt.

Alle genannten Nachteile können durch den Einsatz von niedrigschmelzenden Glaslötwerkstoffen gelöst werden. Dabei liegt die Erweichungstemperatur des Lötwerkstoffes deutlich unterhalb der Einsatztemperatur, sodass die Glasschmelze als eine flüssige Ankopplung dient. Hiermit können Hochtemperaturanwendungen realisiert werden, jedoch keine Anwendungen bei tiefen Temperaturen.

Allerdings weisen solche unter Einsatzbedingungen flüssigen Ankopplungen aufgrund einer starken korrosiven Wirkung der Glasschmelze bei hohen Temperaturen lediglich eine unzureichende Langzeitstabilität auf und sind deshalb ausschließlich für einen Kurzzeiteinsatz geeignet.

Im Unterschied hierzu ist das Aktivlöten eine bekannte Methode der metallischen Verbindung von Oxidwerkstoffen, wobei der Aktivlötwerkstoff eine aktiv oxidierende Komponente enthält. Die Verbindung erfolgt dabei durch eine chemische Reaktion, bei der sich an der Grenzfläche zwischen Aktivlotschmelze und Oxidmaterial eine Aktivschicht bildet, die den Oxidwerkstoff mit der Lötschicht verbindet. Die Implementierung der Aktivlöttechnologie zur Ankopplung eines piezoelektrischen Materials in einem Schallwandler, z.B. Lithiumniobat, an eine Stahlelektrode führt leider durch
- den Einsatz einer Schutz(gas)atmosphäre im Lötprozess und
- eine außergewöhnliche Sauerstoffaktivität des Lithiumniobats
zu einer zu starken chemisch-physikalischen Belastung sowohl des piezoelektrischen Materials als auch des Lötmaterials, was zur Verschlechterung der Langzeitstabilität und zur Beeinträchtigung der Piezoeigenschaften führt. Ähnlichen Herausforderungen können Piezoaktoren, beispielsweise von Hochtemperaturdruckköpfen, und Keramikfilter oder Kontaktdurchführungen von Sensoren ausgesetzt sein.

DE 11 2015 006135 T5 offenbart einen Ultraschallwandler umfassend zwei Metallblöcke, eine Vielzahl von piezoelektrischen Elementen, die rechtwinklige Oberflächen aufweisen und zwischen den Metallblöcken gestapelt sind; und Bonding-Materialien, die die Metallblöcke und das piezoelektrische Element und die piezoelektrischen Elemente miteinander verbinden. Ferner offenbart ist ein entsprechendes Fügeverfahren.

DE 10 2015 101878 A1 offenbart u.a. ein Verfahren zum Herstellen einer Bauelement-Komponente.

### KURZDARSTELLUNG DER ERFINDUNG

Vor diesem Hintergrund wird ein Fügeverfahren nach Anspruch 1 vorgeschlagen, das für den Einsatz in Schallwandlersystemen in den eingangs beschriebenen Messsituationen, insbesondere über den spezifizierten weiten Temperaturbereich, angepasst ist. Die verfahrensgemäß hergestellte Fügeverbindung ermöglicht dauerhaft zugleich eine zuverlässige akustische Ankoppelung und eine zuverlässige elektrische Verbindung zwischen dem piezoelektrischen Material des Schallwandlers und den angekoppelten Elektroden und/oder Vorlaufkörpern über den gesamten spezifizierten Temperaturbereich.

Überraschend erwies sich, dass eine Aktivlotfolie auf nicht-konventionelle Weise als Fügewerkstoff verwendbar ist. Im Gegensatz zum fachüblichen Einsatz einer Aktivlotfolie wird diese erfindungsgemäß bei einer wesentlich niedrigeren Temperatur als der des Schmelzpunktes des Lotmaterials eingesetzt. Untersuchungen der Dynamik der Aktivschichtbildung im Kontakt mit Lithiumniobat, das vorliegend beispielhaft als piezoelektrisches Material verwendet wurde, haben gezeigt, dass auch bei Temperaturen unter dem Schmelzpunkt des Lötwerkstoffes eine mechanisch und elektrisch zuverlässige Verbindung hergestellt werden kann. Vorteilhaft ermöglicht die erfindungsgemäß vorgeschlagene verringerte Prozesstemperatur das Vermeiden eines Aufschmelzens und einer anschließenden Rekristallisation des Fügematerials und führt außerdem zur Verringerung von sonst unvermeidlichen thermischen Spannungen in der Abkühlphase des Fügeprozesses.

Die erfindungsgemäß vorgeschlagene verringerte Prozesstemperatur ermöglicht das Fügen ohne eine Schutzatmosphäre, was nicht nur den Aufwand der Herstellung der Fügeverbindung verringert, sondern auch den negativen Effekt einer Sauerstoffreduktion, d.h. chemische Reduktion des Piezokristalls durch Sauerstoffverlust in der sauerstoffarmen Schutzatmosphäre, und den damit verbundenen Verlust der piezoelektrischen Eigenschaften des als Piezokristall verwendeten Lithiumniobats verhindert (MH Amini, AN Sinclair, TW Coyle (2015) High-temperature ultrasonic transducer for real-time inspection. Physics Procedia 70:343-347).

Im Weiteren wurde überraschend herausgefunden, dass erfindungsgemäß auch eine Metallfolie ohne Zusatz der handelsüblichen Aktivkomponenten in derselben Weise angewendet werden kann. In diesem Zusammenhang wird unter einer Metallfolie ein zu einer Folie gewalztes Metall, wie beispielsweise eine Aluminiumfolie, eine Silberfolie, eine Titanfolie, eine Kupferfolie etc. verstanden.

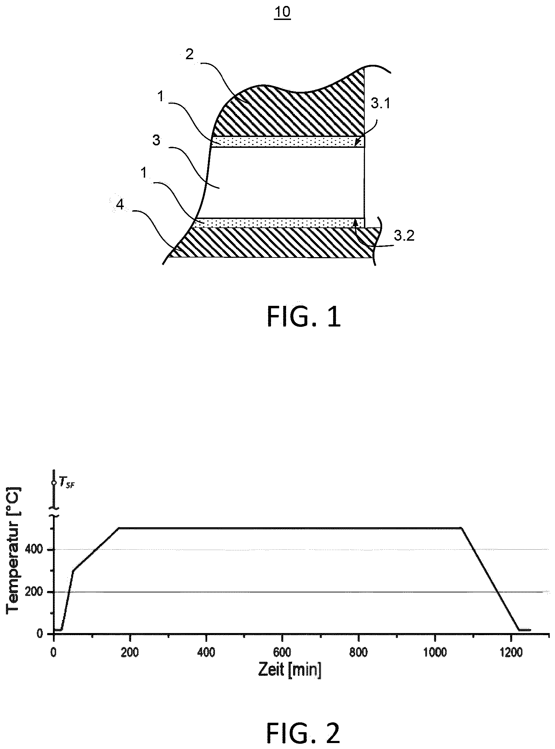

Gemäß typischer Ausführungsformen wird die Verwendung einer Fügefolie als Depot eines Aktivelements gemäß der in Fig. 1 gezeigten Ausführungsform einer Schichtanordnung für das Fügen eines piezokeramischen Materials (Kristall oder Keramik) und betreffender Anschlusselektroden oder als solcher genutzter metallischer Vorlauf- und/oder Dämpfungskörper vorgeschlagen. Das Aktivelement, welches Bestandteil der Fügefolie ist, bildet unter dem Einfluss einer während des Fügeprozesses auf die Fügepartner einwirkenden erhöhten Temperatur und Druck mit einem Bestandteil des piezoelektrischen Materials eine sogenannte Aktivschicht. Die Aktivschicht stellt als gesonderte Phase eine stoffschlüssige Verbindung zwischen dem piezoelektrischen Material und dem Aktivelementdepot her. Ebenso wird eine Aktivschicht zwischen dem Aktivelementdepot und einem Bestandteil des anliegenden Fügepartners, insbesondere einem metallischen Vorlauf- oder Dämpfungskörper, ausgebildet. Durch die kraftschlüssige und/oder stoffschlüssige Verbindung wird eine elektrisch und/oder akustisch (d.h. mechanisch) leitfähige Verbindung zwischen zwei benachbarten Komponenten hergestellt und so die Nutzung des piezoelektrischen Materials in einem Schallwandlersystem ermöglicht.

### KURZBESCHREIBUNG DER FIGUREN

Die beiliegenden Zeichnungen veranschaulichen Ausführungsformen und dienen zusammen mit der Beschreibung der Erläuterung der Prinzipien der Erfindung.
**Fig. 1** zeigt die erfindungsgemäße Anordnung zur Fügung des piezoelektrischen Materials mithilfe von Fügefolien
**Fig. 2** zeigt den Temperaturverlauf über die Zeitdauer des Fügeprozesses. Hierbei bezeichnet T_{SF} einen Schmelzpunkt des Fügematerials bzw. seine Solidustemperatur, falls ein Schmelzintervall vorhanden ist.
**Fig. 3** zeigt das Wachstum der Signalamplitude im Laufe des Fügeprozesses im Zusammenhang mit dem eingesetzten Temperaturprofil.
**Fig. 4** zeigt eine metallographische Aufnahme der hergestellten Fügeschicht.
**Fig.** 5 zeigt den Verlauf der Signalamplitude und der Temperatur im Verlauf des Fügeprozesses mit Fügefolie aus einer Silberbasislegierung und dem piezoelektrischen Material Lithiumniobat.
**Fig. 6** zeigt den Verlauf der Signalamplitude und der Temperatur im Verlauf des Fügeprozesses mit Fügefolie aus Silber und dem piezoelektrischen Material Lithiumniobat.
**Fig. 7** zeigt den Verlauf der Signalamplitude und der Temperatur im Verlauf des Fügeprozesses mit Fügefolie aus Silber und dem piezoelektrischen Material Wismut-Titanat.

### AUSFÜHRUNGSFORMEN

Gemäß einer Ausführungsform wird ein Fügeverfahren zur Herstellung eines Schallwandlersystems für einen Extremtemperatureinsatz von -200°C bis 600°C, insbesondere von -20°C bis 500°C, von -200°C bis 80°C und von -80°C bis 400°C vorgeschlagen, das die folgenden Schritte umfasst:
- Bereitstellen eines piezoelektrischen Materials 3 und einer Mehrzahl von Komponenten, wobei jede der Komponenten durch eine Solidustemperatur gekennzeichnet ist;
- Anordnen des piezoelektrischen Materials 3 und der Mehrzahl der Komponenten in Form eines Stapels 10, sodass benachbart zu einer Vorderseite des piezoelektrischen Materials 3 ein vorderer Stapelteil und benachbart zu einer Rückseite des piezoelektrischen Materials 3 ein rückwärtiger Stapelteil vorliegen; und
- Konsolidieren des Stapels 10 unter Eintrag von Wärme in den Materialstapel und Beaufschlagen des Materialstapels mit Druck, wobei die resultierende Beaufschlagung mit Wärme und Druck für eine vorbestimmte Zeitdauer erfolgt,

wobei während des Konsolidierens das piezoelektrische Material 3 mit einer unmittelbar benachbarten Komponente des vorderen und/oder des rückwärtigen Stapelteils direkt akustisch gekoppelt und/oder elektrisch verbunden wird,
dadurch gekennzeichnet, dass
während des Konsolidierens keine der Solidustemperaturen der Mehrzahl der Komponenten überschritten wird; und
die akustische Ankopplung und/oder elektrische Verbindung ein Ausbilden einer Aktivschicht durch chemische Reaktion eines ersten Bestandteils des piezoelektrischen Materials (3) mit einem zweiten Bestandteil eines Aktivelementdepots umfasst, die eine Phase umfasst, die dem ursprünglich eingesetzten piezoelektrischen Material (3) und dem ungefügten vorderen Stapelteil und/oder dem ursprünglich eingesetzten piezoelektrischen Material (3) und dem ungefügten rückwärtigen Stapelteil fremd ist oder darin lediglich feindispergiert vorliegt.

Mit anderen Worten: Die Aktivschicht umfassende besagte Phase entsteht erst während des Konsolidierens.

Mit anderen Worten ausgedrückt wird ein piezoelektrisches Material bereitgestellt, beispielsweise ein entsprechendes Titanat, Tantalat, Niobat, Orthophosphat oder ein Nitrid; also ein Piezokristall oder eine Piezokeramik. Dieses wird mit den genannten Fügepartnern, die auch als Folie vorliegen können gestapelt, wobei die Fügepartner ausgewählt sind unter einem Dämpfungskörper, einer ersten Elektrode, einer zweiten Elektrode, dem piezoelektrischen Material und einem Vorlaufkörper. Beim Stapeln, d.h. Anordnen der Fügepartner unter Erhalt eines Stapels, wird bevorzugt die nachfolgende Reihenfolge erhalten:
- erste Elektrode und/oder Dämpfungskörper,
- metallische Fügefolie,
- piezoelektrisches Material,
- metallische Fügefolie,
- zweite Elektrode und/oder Vorlaufkörper.

Nachfolgend wird der erhaltene Stapel mit einer Temperatur und optional einem zusätzlichen Anpressdruck beaufschlagt. Die Beaufschlagung mit der Temperatur wird hier auch Temperaturbeaufschlagung genannt, wobei die Temperatur insbesondere unterhalb einer Solidustemperatur aller Komponenten der metallischen Fügefolie liegt. Hierbei wird unter einer Komponente der metallischen Fügefolie ein reines Metall verstanden - wenn die Fügefolie aus nur einem Metall zuzüglich unvermeidbarer begleitender Verunreinigungen dieses Metalls besteht. Ebenso wird unter einer Komponente der metallischen Fügefolie auch jedes andere Metall oder jegliche metallhaltige chemische Verbindung verstanden, die ein oder mehrere Metalle aufweist, die in der Fügefolie vorliegt. Hierbei handelt es sich typischerweise um einen Legierungsbestandteil, beispielsweise um den Bestandteil einer eutektischen Legierung, oder um eine intermetallische Phase.

Während des besagten Beaufschlagens wird zwischen dem Dämpfungskörper und dem piezoelektrischen Material oder der ersten Elektrode und dem piezoelektrischen Material einerseits sowie zwischen dem piezoelektrischen Material und der zweiten Elektrode oder dem piezoelektrischen Material und dem Vorlaufkörper andererseits jeweils eine Aktivschicht ausgebildet, indem zwischen einer oder mehreren Komponenten des betreffenden Fügepartners bzw. einer oder mehreren Komponenten der metallischen Fügefolien und dem piezoelektrischen Material eine chemische Reaktion stattfindet. Die Aktivschicht wird typischerweise in dem zum piezoelektrischen Material benachbarten Fügepartner im Kontaktbereich mit dem piezoelektrischen Material ausgebildet. Diese Aktivschicht gewährleistet - eine entsprechende Ansteuerung mit einem elektrischen Impuls geeigneter Frequenz und Amplitude der als Elektroden genutzten Fügepartner vorausgesetzt - letztlich die akustische Ankopplung einer zu untersuchenden Probe, egal ob über ein zusätzliches zwischen dem erhaltenen Schallwandler und der Probe eingebrachtes Koppelmittel oder trocken/über die umgebende Atmosphäre.

In Abhängigkeit von den für den Vorlaufkörper und für den optional verwendeten Dämpfungskörper verwendeten Materialien kann auf den Einsatz von gesonderten Elektroden verzichtet werden, sofern der Vorlaufkörper und der Dämpfungskörper elektrisch leitfähig sind. In diesem Fall verbindet die metallische Fügefolie den entsprechenden Körper direkt mit dem piezoelektrischen Material, sodass Dämpfungskörper und Vorlaufkörper als erste bzw. zweite Elektroden dienen.

Gemäß einem Ausführungsbeispiel weist die Mehrzahl der neben dem piezoelektrischen Material bereitgestellten Komponenten zumindest eines der folgenden auf: einen Vorlaufkörper; einen Dämpfungskörper, eine Elektrode 2, 4 und ein Aktivelementdepot; wobei das Aktivelementdepot in Form des Vorlaufkörpers, in Form des Dämpfungskörpers, in Form der Elektrode 2, 4 oder in Form einer gesonderten Folie 1 vorliegen kann; wobei der vordere Stapelteil und der rückwärtige Stapelteil jeweils eine Komponente umfassen, die als eine Elektrode ausgebildet ist, bzw. als Elektrode fungiert; und wobei der Vorlaufkörper und der Dämpfungskörper unabhängig voneinander funktional sowohl Elektrode 2, 4 als auch Aktivelementdepot sein können.

Gemäß einer Ausführungsform weist der vordere Stapelteil den Vorlaufkörper und/oder eine Elektrode 2 umfassend ein Aktivelementdepot auf und der rückwärtige Stapelteil weist eine Elektrode 4, 2 umfassend ein Aktivelementdepot und/oder den Dämpfungskörper auf.

Gemäß einer Weiterbildung der vorstehenden Ausführungsform fungiert der Dämpfungskörper auch als Elektrode, bzw. ist als Elektrode ausgebildet und an eine Stromquelle anschließbar. Hierzu ist anzumerken, dass der Dämpfungskörper neben einem Metall, auch eine Keramik sein kann.

Als elektrisch leitfähig (metallähnliche Keramik) sind beispielsweise ZrC, TiC, WC, TiN, ZrN, TiB₂, ZrB₂, TiO, TiSi₂ und MoSi₂ bekannt.

Gemäß einer Ausführungsform wird die Aktivschicht in einer unmittelbar zum piezoelektrischen Material 3 benachbarten Komponente, ausgewählt unter Vorlaufkörper; Dämpfungskörper, Elektrode, und Aktivelementdepot ausgebildet. Insbesondere wird die Aktivschicht in einem Kontaktbereich der unmittelbar zum piezoelektrischen Material 3 benachbarten Komponente mit dem piezoelektrischen Material ausgebildet.

Gemäß einer Ausführungsform sind die Vorderseite 3.2 und die Rückseite 3.1 des piezoelektrischen Materials 3 planparallel zueinander ausgerichtet.

Gemäß einer Ausführungsform weisen die Vorderseite 3.2 und/oder die Rückseite 3.1 des piezoelektrischen Materials 3 und die jeweils unmittelbar benachbarte Oberfläche der Komponente des entsprechenden vorderen Stapelteils und des rückwärtigen Stapelteils eine Rauheit ≤ 1µm auf.

Das begünstigt die der Ausbildung der Aktivschicht zu Grunde liegenden Diffusionsprozesse während des Verfahrensschrittes "Beaufschlagen mit Druck und/oder Temperatur (Wärmeeintrag).

Gemäß einer Ausführungsform ist das das piezoelektrische Material 3 ausgewählt unter: Bleizirkontitanat; Bleilanthanzirkontitanat, Bariumtitanat; Galliumorthophosphat; Lithiumtantalat; Lithiumniobat; Bleititanat; Bleiniobat; einer Verbindung der Langasit-Gruppe, insbesondere einem Lanthan-Gallium-Silikat, Aluminiumnitrid und Bismuthtitanat.

Gemäß einer Ausführungsform umfasst die Aktivschicht dementsprechend eine chemische Verbindung, die ausgewählt ist unter: einem Kupferoxid, einem Kupfertitanat, einem Kupferniobat, einem Silberoxid, einem Silbertitanat, einem Silberniobat einem Titanoxid und einem Titanniobat.

Gemäß einer Ausführungsform erstreckt sich die Aktivschicht im Wesentlichen über die gesamte Ausdehnung einer orthogonal zu einer Stapelrichtung orientierten Querschnittsfläche des Stapels. Mit anderen Worten - wenigstens eine der einander im Wesentlichen gegenüberliegenden Oberflächen des piezoelektrischen Materials ist im Wesentlichen vollständig über die Aktivschicht mit dem unmittelbar benachbarten Fügepartner verbunden.

Gemäß einer Ausführungsform ist das zur Ausbildung der Aktivschicht dienende Aktivelementdepot eine Fügefolie 1 und an der unmittelbar zum piezoelektrischen Material 3 benachbarten Fügefolie 1 werden zwei Aktivschichten ausgebildet, wenn die Fügefolie 1 zwischen dem piezoelektrischen Material 3 und dem Vorlaufkörper angeordnet ist.

Gemäß einer Ausführungsform werden beide vorstehend genannten Aktivschichten an einander gegenüberliegenden Seiten der Fügefolie 1 ausgebildet.

Gemäß einer Ausführungsform unterscheiden sich die beiden Aktivschichten in einer Stärke und/oder in einer chemischen Zusammensetzung.

Gemäß einer Weiterbildung der beiden vorstehenden Ausführungsformen weist der Vorlaufkörper einen Stahl auf und das Aktivelementdepot umfasst eine Silberfolie. Ebenso kann der Vorlaufkörper Kupfer umfassen.

Gemäß einer Ausführungsform umfasst der Vorlaufkörper Silber.

Gemäß einer Ausführungsform ist das Aktivelementdepot eine Folie 1 umfassend Kupfer, Titan, eine kupferbasierte Legierung, oder eine silberbasierte Legierung.

Gemäß einer Ausführungsform umfasst die vorstehend genannte silberbasierte Legierung 63-71% Ag, 26-35% Cu, und 1-5% Ti sowie unvermeidliche Verunreinigungen.

Gemäß einer Ausführungsform ist das Aktivmetalldepot eine Aktivlotfolie.

Vorteilhaft sind Aktivlotfolien unterschiedlicher Spezifikation kommerziell erhältlich.

Gemäß einer Ausführungsform umfasst die Aktivlotfolie zumindest eines von Aluminium, Hafnium, Magnesium, Nickel, Niob, Titan, Vanadium, Yttrium, und Zirkonium.

Gemäß einer Ausführungsform beträgt der beim Konsolidieren aufgewendete Druck 0,1-5 MPa, bevorzugt 0,2-2 MPa.

Gemäß einer Ausführungsform ist eine beim Wärmeeintrag, bzw. beim Beaufschlagen des Stapels mit der Temperatur, bzw. während der Temperaturbeaufschlagung, bzw. während des Konsolidierens des hergestellten Materialstapels umfassend Fügepartner und Fügefolie angewandte Heizrate kleiner oder gleich 100 K/h.

Vorteilhaft wird dadurch vermieden, dass eine Oxidation der Oberfläche des Vorlaufkörpers vor Erreichen der Fügung, d.h. vor dem Ausbilden der Aktivschicht, eintritt.

Gemäß einer Ausführungsform bleibt die Temperatur des Stapels während des Konsolidierens ≤ 600 °C.

Gemäß einer Ausführungsform wird ab einem Erreichen der Temperatur des Stapels von 300°C die Heizrate auf einen Wert eingestellt, der geringer als 100 K/h ist.

Gemäß einer Ausführungsform wird das vorstehend und nachfolgend noch weiter beschriebene Fügeverfahren verwendet zur Herstellung eines Schallwandlers, eines Piezoaktuators, eines Keramikfilters, eines Keramikresonators, eines Zwischenfrequenzfilters oder eines Hochtemperatursensors umfassend eine Keramikdurchführung.

Gemäß einer weiteren Ausführungsform werden zur Herstellung eines Schallwandlersystems zu verbindende Fügepartner wie folgt gestapelt:
erste Elektrode aus Silber;
piezoelektrisches Material Lithiumniobat;
Fügefolie, insbesondere eine Silberfolie; und
Edelstahlvorlauf, der gleichzeitig als zweite Elektrode dient.

In diesem Beispiel erfüllt Silber sowohl die Funktion einer Elektrode als auch die einer Fügefolie, d.h. des Aktivelement-Depots zur Ausbildung der Aktivschicht.

Gemäß einer Ausführungsform umfasst die Fügefolie eine silberbasierte Legierung. Insbesondere handelt es sich bei der silberbasierten Legierung um eine eutektische Silber-Kupfer-Legierung. Als silberbasiert wird hier eine Legierung bezeichnet, die - bezogen auf das Gesamtgewicht - zu einem überwiegenden Anteil Silber mit optionalen weiteren Legierungspartnern (z.B. Kupfer und Titan) und unvermeidlichen Fremdbestandteilen besteht. Dementsprechend wird als kupferbasierte Legierung eine Legierung bezeichnet, die - bezogen auf das Gesamtgewicht - zu einem überwiegenden Anteil Kupfer mit optionalen weiteren Legierungspartnern und unvermeidlichen Fremdbestandteilen besteht.

Gemäß weiterer Ausführungsformen weist die Legierung 70-71% Ag, 26-27% Cu und 2,5-3,5% Ti neben unvermeidlichen Fremdbestandteilen, d.h. Verunreinigungen auf. Wie bereits festgestellt, kann eine Aktivschichtbildung jedoch auch ohne Titan sowohl am Silber als auch am Kupfer erfolgen. Das heißt, dass auch in der hier bezeichneten eutektischen Silber-Kupfer-Legierung Titan nicht als das einzige Aktivelement fungiert. Allgemein wird unter einem Aktivelement ein sauerstoffaffines Element verstanden.

Gemäß beispielhafter Ausführungsformen handelt es sich bei dem Material einer Fügefolie um eine Kupfer-Zinn-Legierung, insbesondere um eine eutektische Kupfer-Zinn-Legierung.

Die kupferbasierten Legierungen weisen in der Regel im Vergleich zu silberbasierten Legierungen eine höhere Aktivität der Oxidbildung auf, was für die Schnelligkeit und Effektivität der Aktivschichtbildung von Vorteil sein kann. Allerdings kann dies im Dauereinsatz eines unter der Bildung von Aktivschichten gefügten Schallwandlers nach längerer Zeit auch nachteilig sein, z.B. durch eine schnellere Degradation der Aktivverbindung.

Gemäß einer weiteren Ausführungsform weist die Fügefolie eine Legierung umfassend ein Aktivelement, zum Beispiel Titan, Zirkonium oder Hafnium, auf.

Durch Zugabe der benannten Aktivelemente zum Material der Fügefolie kann die Effektivität und Intensität der Aktivschichtbildung noch weiter erhöht werden, was die Prozesszeiten verkürzen kann.

Die Prozesszeit wird im Wesentlichen durch die Dauer der Haltezeit nach Erreichen der Fügetemperatur bestimmt. Typische Haltezeiten liegen im Bereich von 10 bis 20 h, beispielsweise zwischen 12 bis 18 h, insbesondere bei 15 h ± 1 h. Die Haltezeit kann beispielsweise 15 h sein.

Unterschiedliche Legierungen weisen eine unterschiedliche Sauerstoffaktivität auf. Wenn eine Fügefolie weniger sauerstoffaktiv ist - wie z.B. eine Fügefolie auf Silberbasis - wird zwar eine längere Fügezeit benötigt, jedoch wird vorteilhaft eine höhere Langzeitstabilität des erhaltenen Schallwandlers im Hochtemperatureinsatz erzielt.

Soll die Fügezeit verkürzt werden, so kann gemäß dem hier vorgeschlagenen Verfahren eine aktivere Legierung, z.B. eine kupferbasierte Legierung, verwendet werden, was aber möglicherweise die Langzeitstabilität und damit die Standzeit, bzw. die Nutzungsdauer des erhaltenen Schallwandlers etwas beeinträchtigt. Durch die Zugabe der Aktivelemente Ti, Zr oder Hf kann die Sauerstoffaktivität noch weiter erhöht werden, was eine weitere Verkürzung der Fügezeit bewirkt, dazu aber möglicherweise eine weiteren Verschlechterung der Langzeitstabilität bewirkt. In Abhängigkeit vom jeweiligen Bewertungskriterium - z.B. vertretbarer Aufwand zur Herstellung oder Standzeit (möglichst lange Lebensdauer), kann somit durch den Fachmann mit vertretbarem Aufwand das Optimum für die jeweilige Anwendung erzielt werden.

Vorteilhaft kann durch das ausgewählte Aktivelement die Sauerstoffaktivität der Fügefolie und somit die Verkürzung der Fügezeit bei der hier vorgeschlagenen Verwendung der Fügefolie in Kombination mit der silberbasierten oder der kupferbasierten Legierung der Fügefolie erzielt werden.

Gemäß einer Ausführungsform eines Herstellungsverfahrens für ein Schallwandlersystem umfassend einem Vorlaufkörper aus Stahl, insbesondere aus einem rostfreien Stahl, beträgt die Erwärmungsgeschwindigkeit (Heizrate) während des Konsolidierens, d.h. beim Beaufschlagen des hergestellten Materialstapels mit der Temperatur unterhalb einer Temperatur von 300°C mehr als 100 K/h.

Vorteilhaft ermöglicht dies einen beschleunigten Prozess zur Fügung bei gleichzeitiger Vermeidung der Oxidation, da rostfreier Stahl erst ab 300°C zu oxidieren beginnt.

Gemäß einer Ausführungsform ist das piezoelektrische Material ausgewählt unter: Bleizirkontitanat; Bariumtitanat; Galliumorthophosphat; Lithiumtantalat; Lithiumniobat; Bleititanat; Bleiniobat; einem Lanthan-Gallium-Silikat (sogenanntes Langasit), Aluminiumnitrid und Bismuthtitanat.

Vorteilhaft ermöglicht dies eine Anpassung an die thermischen Ausdehnungskoeffizienten des verwendeten Vorlaufkörpers und an die jeweils gewünschte Obergrenze der Einsatztemperatur des Schallwandlersystems.

Gemäß einer Ausführungsform wird ein Material der metallischen Elektrode ausgewählt unter: Ag-, Cu-, und Ti- Legierungen.

Vorteilhaft ermöglicht diese Ausführungsform die Nutzung der Elektrode als Fügefolie, d.h. als Aktivelementdepot.

Gemäß einer weiteren Ausführungsform wird vorgeschlagen, eine Fügeschicht zur Herstellung einer hochtemperaturfesten Verbindung zwischen einem Vorlaufkörper und einem piezoelektrischen Material zu verwenden, wobei die Fügeschicht ausgewählt ist unter: einer silberbasierten Legierung, einer kupferbasierten Legierung und einer metallischen Fügefolie und die Legierungen jeweils ein Aktivmetall umfassen, das ausgewählt ist unter Titan, Zirkonium und Hafnium.

Diese Verwendung ermöglicht die bereits zuvor beschriebenen Vorteile.

Die vorstehend beschriebenen Ausführungsformen können beliebig miteinander kombiniert werden.

### DETAILLIERTE BESCHREIBUNG DER ERFINDUNG AN HAND DER FIGUREN

In **Fig. 1** ist die erfindungsgemäß genutzte Anordnung 10 zur Fügung des piezoelektrischen Materials für eine Ausführungsform schematisch dargestellt. Sie umfasst ein piezoelektrisches Material 3 das an zwei einander gegenüberliegenden Seiten 3.1, 3.2 jeweils über eine Fügefolie 1 in stoffschlüssigen Kontakt mit jeweils einer Elektrode gebracht wird, einer inneren Elektrode 2 und einer äußeren Elektrode 4.

Beispielsweise basiert eine erfindungsgemäß nutzbare Fügefolie 1 auf einer eutektischen Ag-Cu-Legierung mit Zugabe von 3 % Titan als Aktivkomponente. Nachfolgende Untersuchungen haben gezeigt, dass die Zugabe einer zusätzlichen Aktivkomponente wie z.B. Titan nicht zwingend erforderlich ist, so dass auch weitere sowohl silber- als auch kupferbasierte Legierungen sowie reine Silber- und Kupferfolien als erfindungsgemäß einsetzbare Fügefolien geeignet sind.

Die einzelnen Komponenten der in **Fig. 1** schematisch gezeigten Anordnung werden zum Fügen in einer Spannvorrichtung mit definierter Presskraft aufeinandergepresst, um einen guten mechanischen Kontakt zwischen piezoelektrischem Material, Aktivlotfolie und Elektroden zu gewährleisten.

Der erfindungsgemäß vorgeschlagene Fügeprozess erfolgt vorteilhaft gemäß dem in **Fig. 2** dargestellten Temperaturverlauf. Der Temperaturverlauf wird während des Fügeprozesses gezielt gesteuert. Insbesondere wird eine Temperatursteigerung je Zeiteinheit (Heizrate) so eingestellt, dass sich an der Oberfläche der metallischen Elektrode keine eigenen Oxide vorzeitig bilden, die eine nachfolgende Aktivschichtbildung im Kontaktgebiet beeinträchtigen können.

Die Ausbildung einer Aktivschicht und somit die dauerhafte akustische Verbindung (Ankopplung) starten mit niedrigen Geschwindigkeiten schon ab ca. 400 °C und beschleunigen sich mit Erhöhung der Temperatur, sodass die Wärmebehandlung bei einer finalen Fügetemperatur von 500 °C die Ausbildung einer flächendeckenden Aktivverbindung zwischen dem piezoelektrischen Material und der Fügefolie eine gute und langzeitstabile Ultraschallübertragung gewährleistet.

Bei der Verwendung eisenhaltiger Elektroden oder Vorlaufmaterialien ist zu beachten, dass ab 300 °C eine Erwärmungsgeschwindigkeit von 100 °C/h nicht überschritten wird, um die Entstehung unerwünschter Eisenoxide in der Grenzschicht zwischen der Fügefolie 1 und den Elektroden 2, 4 zu vermeiden.

Der in **Fig. 2** angegebene Temperaturverlauf gilt für einen Materialstapel aus Stahlelektroden, Lithiumniobat als Piezokristall und Aktivelementdepot in Form einer Fügefolie aus einer eutektischen Ag-Cu-Legierung mit Zugabe von 3 % Titan. Im allgemeinen Fall sind die Fügeprozessparameter anwendungsspezifisch und werden unter Berücksichtigung der Eigenschaften sowohl der Komponenten der metallischen Fügefolie als auch der jeweiligen Fügepartner ausgewählt.

Dabei muss die Fügetemperatur einerseits innerhalb der Grenzen der thermischen Stabilität der Fügepartner liegen, soll aber andererseits möglichst hoch gehalten werden, um eine hinreichend schnelle Aktivschichtbildung am Fügematerial zu ermöglichen, denn diese Geschwindigkeit bestimmt die minimale Haltezeit und somit die Schnelligkeit des Fügeprozesses. Eine in den Materialstapel, beispielsweise mittels einer Spannvorrichtung, eingebrachte Druckkraft kann zwar den Fügeprozess etwas beschleunigen, darf aber selbstredend die mechanische Beanspruchbarkeit der gefügten Werkstoffe (insbesondere die Sprödigkeit des piezoelektrischen Materials) nicht überschreiten.

Das Produkt der o. g. chemischen Reaktion formt zwischen dem Fügematerial und dem Fügepartner, die beide in einem festen Zustand vorliegen, ohne eine zwischenzeitliche Verflüssigung jeglicher Komponenten, die sogenannte Aktivschicht, die mit dem Erreichen einer nahezu hohlraumfreien Füllung des Zwischenraums zwischen den benachbarten Fügepartnern eine flächendeckende schallübertragende Ankopplung gewährleistet.

Beim Beaufschlagen des Stapels der genannten Fügepartner und metallischen Fügefolien mit einer Temperatur darf eine bestimmte Anstiegsgeschwindigkeit nicht überschritten werden. Als günstig für unterschiedliche Kombinationen von Fügepartnern und metallischen Fügefolien hat sich eine maximale Anstiegsgeschwindigkeit der Temperatur von 100°C/h erwiesen.

Beim Fügen einer piezoelektrischen Keramik, wie auch in der späteren Anwendung des mit der Ausbildung wenigstens einer Aktivschicht erzielten Schallwandlers, soll eine verwendete Temperatur die Curietemperatur einer Piezokeramik vorteilhaft nicht erreichen. Hingegen kann bei Verwendung eines Schallwandlers, dessen piezoelektrisches Material eine kristalline Struktur aufweist, beispielsweise Lithiumniobat, die Curietemperatur durchaus überschritten werden. Da im erfindungsgemäß vorgeschlagenen Fügeprozess kein Aufschmelzen erfolgt, kann eine höhere Einsatztemperatur eines Schallwandlers, der einen Piezokristall umfasst, zwar die Langzeitstabilität des Schallwandlers verringern, darf aber prinzipiell auch oberhalb der Fügetemperatur liegen.

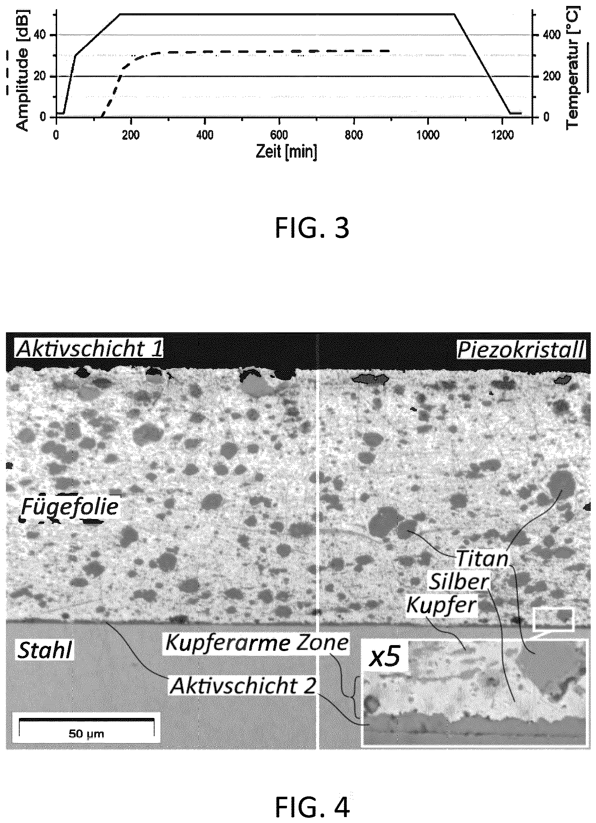

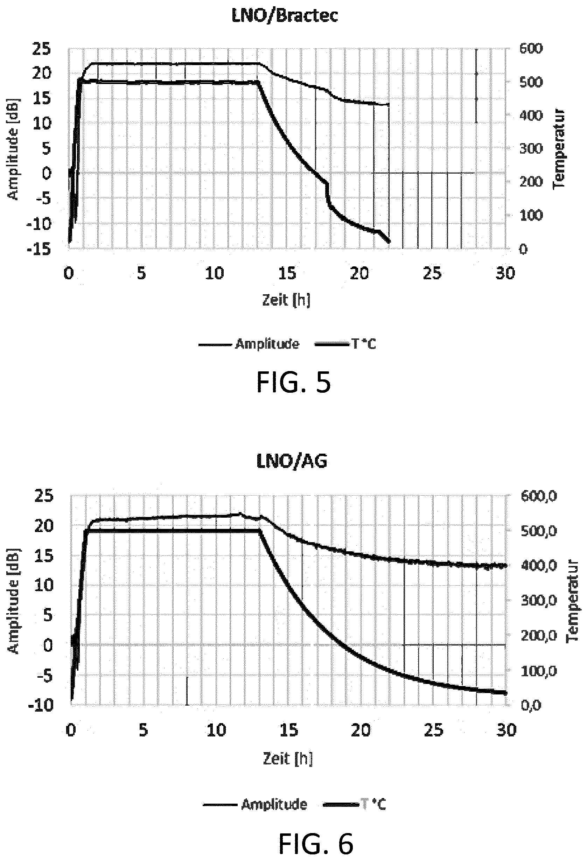

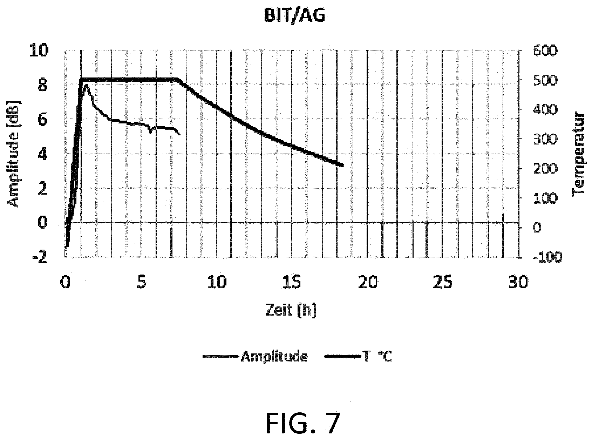

Der bei einer Druckbeaufschlagung des Stapels der Fügepartner ausgeübte Anpressdruck beeinflusst die für die Ausbildung der Aktivschicht erforderliche Fügezeit. Dabei ist die benötigte Fügezeit umgekehrt proportional zum aufgebrachten Anpressdruck. Somit kann über eine Erhöhung des Anpressdrucks die Prozessgeschwindigkeit beschleunigt, bzw. die erforderliche Fügezeit verringert werden: Bei Anwendung einer Presskraft von 100 N auf eine Kombination aus Stahlelektroden, Lithiumniobat als Piezokristall (Dicke 1,83 mm, Durchmesser 20 mm) und Fügefolien aus einer eutektischen Ag-Cu-Legierung mit Zugabe von 3 % Titan (Foliendicke 100 µm) mit einem resultierenden Anpressdruck von 0,3 MPa kann eine gute akustische Ankopplung nach 15 Stunden Fügezeit bei 500 °C erzielt werden. Zur Charakterisierung der akustischen Ankopplung wurde die Amplitude eines durchgehenden Ultraschallsignals ausgewertet. (siehe **Fig. 3****).** Zum Fügen von Lithiumniobat als Piezokristall auf einen Vorlaufkörper aus Stahl mit beidseitiger Silberfolie als Elektrode wurde mit einer Anpresskraft von 400 N bei einer Fügezeit von 12 h eine gute akustische Ankopplung erzielt (vgl. **Fig. 6****).** Die Abmaße des Piezokristalls betrugen 10x20mm, der Anpressdruck betrug also 2MPa. Unter identischen Bedingungen wurde auch mit Bismuthtitanat als Piezokeramik auf einem Vorlaufkörper aus Stahl mit beidseitig auf dem piezoelektrischen Material angeordneter Silberfolie als Elektrode eine gute akustische Ankopplung erzielt (vgl. **Fig. 7****).** Hierbei wird unter einer guten akustischen Ankopplung eine kraftschlüssige Verbindung verstanden, die eine zuverlässige Übertragung akustischer Schwingungen im Bereich von 10 kHz - 10 MHz, insbesondere von 50 kHz - 5 MHz, beispielsweise von 100 kHz - 4 MHz erlaubt.

Zur zuverlässigen Ausbildung einer Aktivschicht und also für das erfolgreiche Fügen weisen die Fügeflächen vorteilhaft eine definierte Oberflächengüte auf. Bevorzugt werden die Fügeflächen des piezoelektrischen Materials planparallel zueinander ausgeführt und auf eine Rauheit von weniger als ein Mikrometer poliert.

Die Anwendung einer Fügefolie ist in Abhängigkeit vom verwendeten Vorlaufkörper (z.B. Kupfer) optional. Das heißt, dass bei der Verwendung eines Kupfer-Vorlaufkörpers im Materialstapel das Kupfer als ein Depot des Aktivelements (quasi als Fügefolie) zur Ausbildung der Aktivschicht dient und zusätzlich die Funktion der Elektrode erfüllt. Wenn also der Piezokristall direkt auf den Kupfervorlaufkörper angelegt und mit einer Anpresskraft eingespannt wird, kann sich bei 500 °C zwischen beiden eine Aktivschicht ausbilden und somit kann die Ausbildung einer Aktivverbindung (Aktivschicht) und eine akustische Ankopplung ohne Fügefolie erfolgen. Wenn das Material des Vorlaufkörpers (a) leitend ist und (b) im Kontakt mit dem verwendeten Piezoschwinger während des Fügens eine Aktivschicht bildet, so kann auf die Verwendung einer gesonderten Fügefolie verzichtet werden.

### PRAKTISCHES AUSFÜHRUNGSBEISPIEL

Fig. 4 zeigt eine metallographische Aufnahme einer beispielhaft hergestellten Fügeschicht bei der Fügung eines Lithiumniobat-Piezokristalls mit einer Stahlelektrode mittels einer Fügefolie aus einer 3 Masse-% Titan enthaltenden eutektischen Ag-Cu-Legierung nach 15 Stunden Fügezeit bei 500 °C. Obwohl diese Fügetemperatur um ca. 180 °C unter der Solidustemperatur des Fügematerials liegt, ist klar erkennbar, dass an beiden Seiten der Folie eine Aktivschicht ausgebildet wurde, also eine chemische Reaktion benachbarter Komponenten erfolgte. Gemäß der Theorie beinhaltet die Aktivschicht im Wesentlichen Titanoxid. Allerding haben nachfolgende Versuche gezeigt, dass auch titanfreie Folien sowohl aus reinem Kupfer als auch aus reinem Silber als Fügematerial zur beidseitigen Ausbildung von Aktivschichten führen und eine vergleichbare Fügequalität gewährleisten. Das belegt, dass auch die Elemente Kupfer und Silber jeweils die Ausbildung einer Aktivschicht bewirken und somit möglicherweise in der abgebildeten Aktivschicht ebenso enthalten sind. Dafür spricht auch die Phasenverteilung der Komponenten in der Fügefolie nach dem erfolgten Fügeprozess: Während sich der mittlere Bereich der Folie kaum von einer ursprünglichen Phasenverteilung in der verwendeten Folie unterscheidet, beinhalten die unmittelbar zu den Aktivschichten benachbarten Bereiche wesentlich weniger bis gar kein Kupfer.

Das entwickelte Fügeprinzip resultiert im Vergleich zu der vorbekannten hochtemperaturbeständigen Koppeltechnik mit flüssigem Glas (EP 0 459 431 B1) in einer wesentlich höheren Langzeittemperaturstabilität, benötigt keine aufwendigen Schutzmaßnahmen gegen einen Korrosionsangriff, die im Falle einer Glasschmelze erforderlich wären, und ermöglicht außerdem den Einsatz der einmal gefügten Bindungspartner auch unter niedrigen Temperaturen, während die Ankopplung über eine Glasschmelze (Glasankopplung) nur oberhalb der Erweichungstemperatur des Glases ab ca. 350 °C einsetzbar ist.

Aspekte der vorliegenden Erfindung lassen sich gemäß den nachfolgenden Punkten ergänzend beschreiben:
1. Herstellung einer Aktiv-Fügeverbindung mit Hilfe einer Fügefolie bei einer Temperatur, die deutlich unter dem Schmelzpunkt der Fügefolie (Lotschmelzpunkt) bzw. ihrer Solidustemperatur, falls ein Schmelzintervall vorhanden ist, liegt;
2. Fügeverfahren zur Fügung eines piezoelektrischen Materials auf einen Schallvorlaufkörper mittels einer während des Fügens ausgebildeten Fügeschicht, die hier als Aktivschicht bezeichnet wird;
3. Aufbau eines Materialstapels entsprechend der Beschreibung der Erfindung;
4. Schallwandlersystem auf Basis der beschriebenen Fügetechnik;
5. Schallwandlersystem mit Winkeleinschallung auf Basis der beschriebenen Fügetechnik;
6. Schallwandlersystem für Durchflussmessung auf Basis der beschriebenen Fügetechnik;
7. Multi-Schallwandlersystem für Durchflussmessung auf Basis der beschriebenen Fügetechnik.
8. Fügeverfahren zur Herstellung eines Schallwandlersystems (10) für einen Extremtemperatureinsatz.

Die vorliegende Erfindung wurde anhand von allgemeinen Erläuterungen, Aspekten, Ausführungsformen und praktischen Ausführungsbeispielen erläutert. Diese Ausführungsbeispiele sollten keinesfalls als einschränkend für die vorliegende Erfindung verstanden werden. Die nachfolgenden Ansprüche stellen einen ersten, nicht bindenden Versuch dar, die Erfindung allgemein zu definieren.

### BEZUGSZEICHEN

- 1: Folie, Fügefolie, Aktivlotfolie
- 2: Dämpfungskörper und/oder innere Elektrode
- 3: piezoelektrisches Material
- 3.1, 3.2: einander gegenüberliegende Oberflächen des piezoelektrischen Materials
- 4: Vorlaufkörper und/oder äußere Elektrode
- 10: Stapel, Fügeanordnung (Ausschnitt)

## Patentansprüche

1. Fügeverfahren zur Herstellung eines Schallwandlersystems, umfassend:
- Bereitstellen eines piezoelektrischen Materials (3) und einer Mehrzahl von Komponenten, wobei jede der Komponenten durch eine Solidustemperatur gekennzeichnet ist;
- Anordnen des piezoelektrischen Materials (3) und der Mehrzahl der Komponenten in Form eines Stapels (10), sodass benachbart zu einer Vorderseite des piezoelektrischen Materials (3) ein vorderer Stapelteil und benachbart zu einer Rückseite des piezoelektrischen Materials (3) ein rückwärtiger Stapelteil vorliegen; und
- Konsolidieren des Stapels (10) unter Verwendung von Wärme und Druck für eine vorbestimmte Zeitdauer,
wobei während des Konsolidierens das piezoelektrische Material (3) mit einer unmittelbar benachbarten Komponente des vorderen und/oder des rückwärtigen Stapelteils direkt akustisch gekoppelt und/oder elektrisch verbunden wird,
**dadurch gekennzeichnet, dass**
keine der Solidustemperaturen der Mehrzahl der Komponenten überschritten wird; und
die akustische Ankopplung und/oder elektrische Verbindung ein Ausbilden einer Aktivschicht durch chemische Reaktion eines ersten Bestandteils des piezoelektrischen Materials (3) mit einem zweiten Bestandteil eines Aktivelementdepots umfasst, die eine Phase umfasst, die dem ursprünglich eingesetzten piezoelektrischen Material (3) und dem ungefügten vorderen Stapelteil und/oder dem ursprünglich eingesetzten piezoelektrischen Material (3) und dem ungefügten rückwärtigen Stapelteil fremd ist oder darin lediglich feindispergiert vorliegt.

2. Fügeverfahren nach Anspruch 1, wobei die Mehrzahl von Komponenten zumindest eines der folgenden aufweist: einen Vorlaufkörper; einen Dämpfungskörper, eine Elektrode (2, 4), und das Aktivelementdepot; wobei das Aktivelementdepot in Form des Vorlaufkörpers, in Form des Dämpfungskörpers, in Form der Elektrode (2, 4) oder in Form einer gesonderten Folie (1) vorliegen kann;
wobei der vordere Stapelteil und der rückwärtige Stapelteil jeweils eine Komponente umfassen, die jeweils als eine Elektrode ausgebildet ist; und
wobei der Vorlaufkörper und der Dämpfungskörper unabhängig voneinander funktional sowohl Elektrode (2, 4) als auch Aktivelementdepot sein können.

3. Fügeverfahren nach Anspruch 2, wobei der vordere Stapelteil den Vorlaufkörper und/oder eine Elektrode (2) umfassend das Aktivelementdepot aufweist; und der rückwärtige Stapelteil die Elektrode (4, 2) umfassend das Aktivelementdepot und/oder den Dämpfungskörper aufweist.

4. Fügeverfahren nach Anspruch 3, wobei der Dämpfungskörper auch als Elektrode (2, 4) ausgebildet ist.

5. Fügeverfahren nach Anspruch 4, wobei die Aktivschicht in einer unmittelbar zum piezoelektrischen Material (3) benachbarten Komponente, ausgewählt unter Vorlaufkörper; Dämpfungskörper, Elektrode, und Aktivelementdepot ausgebildet wird, wobei die Aktivschicht in einem Kontaktbereich der unmittelbar zum piezoelektrischen Material (3) benachbarten Komponente mit dem piezoelektrischen Material ausgebildet wird.

6. Fügeverfahren nach einem der Ansprüche 1 bis 5, wobei die Vorderseite und die Rückseite des piezoelektrischen Materials (3) planparallel zueinander ausgerichtet sind.

7. Fügeverfahren nach einem der Ansprüche 1 bis 6, wobei die Vorder- und/oder die Rückseite des piezoelektrischen Materials (3) und die jeweils unmittelbar benachbarte Oberfläche der Komponente des vorderen Stapelteils und des rückwärtigen Stapelteils eine Rauheit ≤ 1 µm aufweisen.

8. Fügeverfahren nach einem der Ansprüche 1 bis 7, wobei das piezoelektrische Material (3) ausgewählt ist unter: Bleizirkontitanat; Bleilanthanzirkontitanat, Bariumtitanat; Galliumorthophosphat; Lithiumtantalat; Lithiumniobat; Bleititanat; Bleiniobat; einer Verbindung der Langasit-Gruppe, insbesondere einem Lanthan-Gallium-Silikat, Aluminiumnitrid und Bismuthtitanat.

9. Fügeverfahren nach einem der Ansprüche 1 bis 8, wobei die Aktivschicht eine chemische Verbindung umfasst, die ausgewählt ist unter: einem Kupferoxid, einem Kupfertitanat, einem Kupferniobat, einem Silberoxid, einem Silbertitanat, einem Silberniobat einem Titanoxid und einem Titanniobat.

10. Fügeverfahren nach Anspruch 9, wobei die Aktivschicht im Wesentlichen eine gesamte Ausdehnung einer orthogonal zu einer Stapelrichtung ausgerichteten Querschnittsfläche des Stapels umfasst.

11. Fügeverfahren nach Anspruch 9 oder 10, wobei das Aktivelementdepot eine Fügefolie (1) ist und an der unmittelbar zum piezoelektrischen Material (3) benachbarten Fügefolie (1) zwei Aktivschichten ausgebildet werden, wenn die Fügefolie (1) zwischen dem piezoelektrischen Material (3) und dem Vorlaufkörper angeordnet ist.

12. Fügeverfahren nach Anspruch 11, wobei die beiden Aktivschichten an einander gegenüberliegenden Seiten der Fügefolie (1) ausgebildet werden.

13. Fügeverfahren nach Anspruch 11 oder 12, wobei sich die beiden Aktivschichten in einer Stärke und/oder einer chemischen Zusammensetzung unterscheiden.

14. Fügeverfahren nach einem der Ansprüche 2 bis 13, wobei der Vorlaufkörper einen Stahl aufweist und das Aktivelementdepot eine Silberfolie umfasst, oder der Vorlaufkörper Kupfer aufweist.

15. Fügeverfahren nach einem der Ansprüche 2 bis 13, wobei der Vorlaufkörper Silber umfasst.

16. Fügeverfahren nach einem der Ansprüche 2 bis 13, wobei das Aktivelementdepot eine Folie (1) umfassend Kupfer, Titan, eine kupferbasierte Legierung, oder eine silberbasierte Legierung umfasst.

17. Fügeverfahren nach Anspruch 16, wobei die silberbasierte Legierung 63-71% Ag, 26-35% Cu, und 1-5% Ti sowie unvermeidliche Verunreinigungen umfasst.

18. Fügeverfahren nach Anspruch 2 bis 13, wobei das Aktivmetalldepot eine Aktivlotfolie (1) ist.

19. Fügeverfahren nach Anspruch 18, wobei die Aktivlotfolie (1) zumindest eines von Aluminium, Hafnium, Magnesium, Nickel, Niob, Titan, Vanadium, Yttrium, und Zirkonium umfasst.

20. Fügeverfahren nach einem der Ansprüche 1 bis 19, wobei der beim Konsolidieren aufgewendete Druck 0,1-5 MPa, bevorzugt 0,2-2 MPa beträgt.

21. Fügeverfahren nach einem der Ansprüche 1 bis 20, wobei eine Heizrate beim Konsolidieren ≤ 100 K/h beträgt.

22. Fügeverfahren nach einem der Ansprüche 1 bis 21, wobei eine Temperatur des Stapels (10) während des Konsolidierens ≤ 600 °C ist.

23. Fügeverfahren nach Anspruch 22, wobei die Heizrate ab einem Erreichen der Temperatur des Stapels (10) von 300°C geringer als 100 K/h ist.

24. Verwendung des Fügeverfahrens nach einem der Ansprüche 1-23 zur Herstellung eines Schallwandlers, eines Piezoaktuators, eines Keramikfilters, eines Keramikresonators, eines Zwischenfrequenzfilters oder eines Hochtemperatursensors umfassend eine Keramikdurchführung.

## Claims

1. Joining method for manufacturing a sound transducer system, comprising:
- providing a piezoelectric material (3) and a plurality of components, each of the components being **characterised by** a solidus temperature;
- arranging the piezoelectric material (3) and the plurality of components in the form of a stack (10) so that there is a front stack part adjacent to a front side of the piezoelectric material (3) and a rear stack part adjacent to a rear side of the piezoelectric material (3); and
- consolidating the stack (10) using heat and pressure for a predetermined period of time,
wherein, during consolidation, the piezoelectric material (3) is directly acoustically coupled and/or electrically connected to an immediately adjacent component of the front and/or rear stack part, **characterised in that**
none of the solidus temperatures of the plurality of components is exceeded;
and the acoustic coupling and/or electrical connection comprises the formation of an active layer through chemical reaction of a first component of the piezoelectric material (3) with a second component of an active element deposit comprising a phase which is foreign to the piezoelectric material (3) originally used and the unjoined front stack part and/or the piezoelectric material (3) originally used and the unjoined rear stack part or is only present therein in finely dispersed form.

2. Joining method according to claim 1, wherein the plurality of components comprises at least one of the following: a delay line; a damping body, an electrode (2, 4) and the active element deposit; wherein the active element deposit may be in the form of the delay line, in the form of the damping body, in the form of the electrode (2, 4) or in the form of a separate film (1);
wherein the front stack part and the rear stack part in each case comprise a component which is in each case designed as an electrode; and
wherein the delay line and the damping body can, independently of each other, be functionally both an electrode (2, 4) and an active element deposit.

3. Joining method according to claim 2, wherein the front stack part contains the delay line and/or an electrode (2) comprising the active element deposit; and the rear stack part contains the electrode (4, 2) comprising the active element deposit and/or the damping body.

4. Joining method according to claim 3, wherein the damping body is also designed as an electrode (2, 4).

5. Joining method according to claim 4, wherein the active layer is formed in a component immediately adjacent to the piezoelectric material (3), selected from delay line, damping body, electrode and active element deposit, wherein the active layer is formed in a contact region of the component immediately adjacent to the piezoelectric material (3) with the piezoelectric material.

6. Joining method according to one of the claims 1 to 5, wherein the front side and rear side of the piezoelectric material (3) are aligned plane-parallel to each other.

7. Joining method according to one of the claims 1 to 6, wherein the front and/or rear side of the piezoelectric material (3) and the immediately adjacent surface of the component of the front stack part and the rear stack part have a roughness ≤1 um.

8. Joining method according to one of the claims 1 to 7, wherein the piezoelectric material (3) is selected from: lead zirconium titanate; lead lanthanum zirconium titanate, barium titanate; gallium orthophosphate; lithium tantalate; lithium niobate; lead titanate; lead niobate; a compound of the langasite group, in particular a lanthanum gallium silicate, aluminium nitride and bismuth titanate.

9. Joining method according to one of the claims 1 to 8, wherein the active layer comprises a chemical compound selected from: a copper oxide, a copper titanate, a copper niobate, a silver oxide, a silver titanate, a silver niobate, a titanium oxide and a titanium niobate.

10. Joining method according to claim 9, wherein the active layer substantially comprises an overall extent of a cross-sectional area of the stack aligned orthogonally to a stacking direction.

11. Joining method according to claim 9 or 10, wherein the active element deposit is a joining film (1) and two active layers are formed on the joining film (1) immediately adjacent to the piezoelectric material (3) if the joining film (1) is arranged between the piezoelectric material (3) and the delay line.

12. Joining method according to claim 11, wherein the two active layers are formed on opposite sides of the joining film (1).

13. Joining method according to claim 11 or 12, wherein the two active layers differ in thickness and/or chemical composition.

14. Joining method according to one of the claims 2 to 13, wherein the delay line comprises a steel and the active element deposit comprises a silver film, or the delay line comprises copper.

15. Joining method according to one of the claims 2 to 13, wherein the delay line comprises silver.

16. Joining method according to one of the claims 2 to 13, wherein the active element deposit comprises a film (1) comprising copper, titanium, a copper-based alloy or a silver-based alloy.

17. Joining method according to claim 16, wherein the silver-based alloy comprises 63-71% Ag, 26-35% Cu and 1-5% Ti as well as unavoidable impurities.

18. Joining method according to claims 2 to 13,
wherein the active metal deposit is an active brazing film (1).

19. Joining method according to claim 18, wherein the active brazing film (1) comprises at least one of aluminum, hafnium, magnesium, nickel, niobium, titanium, vanadium, yttrium, and zirconium.

20. Joining method according to one of the claims 1 to 19, wherein the pressure applied during consolidation is 0.1-5 MPa, preferably 0.2-2 MPa.

21. Joining method according to one of the claims 1 to 20, wherein a heating rate during consolidation is ≤100 K/h.

22. Joining method according to one of the claims 1 to 21, wherein a temperature of the stack (10) during consolidation is ≤600 °C.

23. Joining method according to claim 22, wherein the heating rate after the stack (10) reaches a temperature of 300°C is less than 100 K/h.

24. Use of the joining method according to one of the claims 1-23 for the manufacture of a sound transducer, a piezo actuator, a ceramic filter, a ceramic resonator, an intermediate frequency filter or a high-temperature sensor comprising a ceramic feedthrough.

## Revendications

1. Procédé d'assemblage pour la fabrication d'un système de transducteur acoustique, comprenant :
- la mise à disposition d'un matériau piézoélectrique (3) et d'une pluralité de composants, chacun des composants étant **caractérisé par** une température de solidus ;
- la disposition du matériau piézoélectrique (3) et de la pluralité de composants sous la forme d'un empilement (10), de telle sorte qu'une partie avant de l'empilement est adjacente à une face avant du matériau piézoélectrique (3) et qu'une partie arrière de l'empilement est adjacente à une face arrière du matériau piézoélectrique (3) ; et
- la consolidation de l'empilement (10) en utilisant de la chaleur et de la pression pendant une durée prédéterminée,
le matériau piézoélectrique (3) étant, pendant la consolidation, directement couplé acoustiquement et/ou relié électriquement à un composant immédiatement adjacent de la partie avant et/ou arrière de l'empilement, **caractérisé en ce qu'**
aucune des températures de solidus de la pluralité de composants n'est dépassée ;
et le couplage acoustique et/ou la connexion électrique comprend la formation d'une couche active par réaction chimique d'un premier composant du matériau piézoélectrique (3) avec un deuxième composant d'un dépôt d'élément actif, qui comprend une phase étrangère au matériau piézoélectrique (3) initialement utilisé et la partie avant non assemblée de l'empilement et/ou le matériau piézoélectrique (3) initialement utilisé et la partie arrière non assemblée de l'empilement, ou n'y est présente que sous forme finement dispersée.

2. Procédé d'assemblage selon la revendication 1, dans lequel la pluralité de composants comprend au moins l'un des éléments suivants : un élément de guidage ; un élément d'amortissement, une électrode (2, 4) et le dépôt d'élément actif ; le dépôt d'élément actif pouvant se présenter sous la forme de l'élément de guidage, sous la forme de l'élément d'amortissement, sous la forme de l'électrode (2, 4) ou sous la forme d'une feuille séparée (1) ;
la partie avant de l'empilement et la partie arrière de l'empilement comprenant chacune un composant qui est formé respectivement comme une électrode ; et
l'élément de guidage et l'élément d'amortissement pouvant, indépendamment l'un de l'autre, être fonctionnellement une électrode (2, 4) ou un dépôt d'élément actif.

3. Procédé d'assemblage selon la revendication 2, dans lequel la partie avant de l'empilement comprend l'élément de guidage et/ou une électrode (2) comportant le dépôt d'élément actif ; et la partie arrière de l'empilement comprend l'électrode (4, 2) comportant le dépôt d'élément actif et/ou l'élément d'amortissement.

4. Procédé d'assemblage selon la revendication 3, dans lequel l'élément d'amortissement est également conçu comme une électrode (2, 4).

5. Procédé d'assemblage selon la revendication 4, dans lequel la couche active est formée dans un composant directement adjacent au matériau piézoélectrique (3), choisi parmi un élément de guidage, un élément d'amortissement, une électrode et un dépôt d'élément actif, la couche active étant formée dans une zone de contact du composant directement adjacent au matériau piézoélectrique (3) avec ledit matériau piézoélectrique.

6. Procédé d'assemblage selon l'une des revendications 1 à 5, dans lequel la face avant et la face arrière du matériau piézoélectrique (3) sont alignées de manière plane et parallèle l'une par rapport à l'autre.

7. Procédé d'assemblage selon l'une des revendications 1 à 6, dans lequel la face avant et/ou la face arrière du matériau piézoélectrique (3) et la surface immédiatement adjacente du composant de la partie avant/arrière de l'empilement présentent une rugosité ≤1 um.

8. Procédé d'assemblage selon l'une des revendications 1 à 7, dans lequel le matériau piézoélectrique (3) est choisi parmi les suivants : titano-zirconate de plomb ; titano-zirconate de plomb-lantane ; titanate de baryum ; orthophosphate de gallium ; tantalate de lithium ; niobate de lithium ; titanate de plomb ; niobate de plomb ; un composé du groupe des langasites, en particulier un silicate de lanthane et de gallium ; nitrure d'aluminium ; et titanate de bismuth.

9. Procédé d'assemblage selon l'une des revendications 1 à 8, dans lequel la couche active comprend un composé chimique choisi parmi : un oxyde de cuivre, un titanate de cuivre, un niobate de cuivre, un oxyde d'argent, un titanate d'argent, un niobate d'argent, un oxyde de titane et un niobate de titane.

10. Procédé d'assemblage selon la revendication 9, dans lequel la couche active couvre sensiblement toute la surface de la section transversale de l'empilement, orientée orthogonalement par rapport à la direction d'empilement.

11. Procédé d'assemblage selon la revendication 9 ou 10, dans lequel le dépôt d'élément actif est une feuille d'assemblage (1) et deux couches actives sont formées sur la feuille d'assemblage (1) immédiatement adjacente au matériau piézoélectrique (3), lorsque la feuille d'assemblage (1) est disposée entre le matériau piézoélectrique (3) et l'élément de guidage.

12. Procédé d'assemblage selon la revendication 11, dans lequel les deux couches actives sont formées sur des faces opposées de la feuille d'assemblage (1).

13. Procédé d'assemblage selon la revendication 11 ou 12, dans lequel les deux couches actives diffèrent par leur épaisseur et/ou leur composition chimique.

14. Procédé d'assemblage selon l'une des revendications 2 à 13, dans lequel l'élément de guidage est en acier et le dépôt d'élément actif comprend une feuille d'argent, ou l'élément de guidage est en cuivre.

15. Procédé d'assemblage selon l'une des revendications 2 à 13, dans lequel l'élément de guidage comprend de l'argent.

16. Procédé d'assemblage selon l'une des revendications 2 à 13, dans lequel le dépôt d'élément actif comprend une feuille (1) comprenant du cuivre, du titane, un alliage à base de cuivre ou un alliage à base d'argent.

17. Procédé d'assemblage selon la revendication 16, dans lequel l'alliage à base d'argent comprend 63 à 71 % d'Ag, 26 à 35 % de Cu et 1 à 5 % de Ti, ainsi que des impuretés inévitables.

18. Procédé d'assemblage selon les revendications 2 à 13, dans lequel le dépôt de métal actif est une feuille de soudure active (1).

19. Procédé d'assemblage selon la revendication 18, dans lequel la feuille d'alliage actif (1) comprend au moins l'un des éléments suivants : aluminium, hafnium, magnésium, nickel, niobium, titane, vanadium, yttrium et zirconium.

20. Procédé d'assemblage selon l'une des revendications 1 à 19, dans lequel la pression appliquée lors de la consolidation est comprise entre 0 et 5 MPa, de préférence entre 0,2 et 2 MPa.

21. Procédé d'assemblage selon l'une des revendications 1 à 20, dans lequel la vitesse de chauffage lors de la consolidation est ≤ 100 K/h.

22. Procédé d'assemblage selon l'une des revendications 1 à 21, dans lequel la température de l'empilement (10) pendant la consolidation est ≤ 600 °C.

23. Procédé d'assemblage selon la revendication 22, dans lequel la vitesse de chauffage est inférieure à 100 K/h dès que la température de l'empilement (10) atteint 300 °C.

24. Utilisation du procédé d'assemblage selon l'une des revendications 1 à 23 pour la fabrication d'un transducteur acoustique, d'un actionneur piézoélectrique, d'un filtre céramique, d'un résonateur céramique, d'un filtre à fréquence intermédiaire ou d'un capteur haute température comprenant une traversée céramique.
